Europäisches Patentamt

European Patent Office

Office européen des brevets

(19)

(11) Veröffentlichungsnummer: **0 382 091**
**A2**

(12) ## EUROPÄISCHE PATENTANMELDUNG

(21) Anmeldenummer: 90101992.7

(22) Anmeldetag: 01.02.90

(51) Int. Cl.5: **H04Q 1/14, H05K 9/00**

(30) Priorität: 09.02.89 DE 3903787

(43) Veröffentlichungstag der Anmeldung:
**16.08.90 Patentblatt 90/33**

(84) Benannte Vertragsstaaten:
**AT BE CH DE ES FR GB IT LI NL SE**

(71) Anmelder: **Standard Elektrik Lorenz Aktiengesellschaft**
**Lorenzstrasse 10**
**D-7000 Stuttgart 40(DE)**

(72) Erfinder: **Fogiszinger, Josef**
**Im Weizen 7**
**D-7014 Kornwestheim(DE)**
Erfinder: **Schwarz, Manfred**
**Schiessrainweg 5/1**
**D-7252 Weil der Stadt(DE)**
Erfinder: **Seitz, Christian**
**Keltenstrasse 30**
**D-7253 Renningen(DE)**

(74) Vertreter: **Graf, Georg Hugo, Dipl.-Ing. et al**
**Standard Elektrik Lorenz AG Patent- und Lizenzwesen Postfach 30 09 29**
**D-7000 Stuttgart 30(DE)**

(54) **Eingangsverteiler für Fernsprechnebenstellenanlagen.**

(57) Der Eingangsverteiler weist einen Baugruppenträger mit einer Blechrückwand (1) auf, die mit Durchbrüchen (4) für die Anschlußleisten (3) der einschiebbaren Baugruppe (2) versehen ist. Die Baugruppen (2) tragen neben ihren Anschlußleisten (5) Kontaktfedern (7), die in entsprechende Durchbrüche (8) der Rückwand (1) eingreifen, die eine Abschirmung bildet. Über die Kontaktfedern werden sowohl Überspannungen als auch Störstrahlungen abgeleitet.

*Fig. 2*

EP 0 382 091 A2

## Eingangsverteiler für Fernsprechnebenstellenanlagen

Die Erfindung betrifft einen Eingangsverteiler für Fernsprechnebenstellenanlagen nach dem Oberbegriff des Anspruchs 1.

Bei Nebenstellenanlagen sind die Eingangsverteiler, je nach Größe der Anlage, entweder in einem der Gestelle gesondert, oder in einem Gestell angeordnet, in dem auch Schalteinrichtungen untergebracht sind. Geschlossene Gestelle oder Schränke werden durch Anbringen einer Verkleidung am Gestellrahmen gebildet und gleichen damit im Inneren den offenen Gestellen. Im Gestellrahmen sind die Baugruppenträger oder -rahmen befestigt, in die die Baugruppen eingeschoben sind. Über rückseitige Steckverbinder (Anschlußleisten) sind die Baugruppen an die Verdrahtungsrückwand des jeweiligen Baugruppenträgers angeschlossen, an deren Außenseite die internen Kabel angesteckt sind. Letztere führen entweder zum Hauptverteiler oder zu Sicherungen und zur Stromversorgung im Oberteil des Gestells oder auch zu benachbarten Gestellen (Elektr. Nachrichtenwesen, Band 56, Nr. 2/3, 1981, Seiten 283 bis 292).

Da jede Signalleitung am Eingang gegen Überspannungen geschützt werden muß, die im Fernmeldenetz durch Blitzeinwirkung oder Beeinflussung durch benachbarte elektrische Energieanlagen hervorgerufen werden können, sind im Hauptverteiler Überspannungsableiter angebracht. Seit die analoge Technik durch die digitale ersetzt wird, ist es außerdem notwendig, die Vermittlungsanlagen störstrahlungsdicht zu machen, d.h. die Gestelle und Baugruppenträger müssen mit einer umfassenden Abschirmung versehen sein, die Störstrahlungen weder hinein- noch herausläßt. Durchgänge durch die Abschirmung stellen die Kabel dar, für die besondere Maßnahmen getroffen werden müssen, um den Durchtritt von Störstrahlungen zu unterdrücken.

Aus der DE-OS 34 12 131 ist ein Eingangsverteiler für Fernsprechnebenstellenanlagen bekannt, bei dem in einem Baugruppenträger etwa in der Mitte eine Verdrahtungsplatte senkrecht zur Steckrichtung der Baugruppen angeordnet ist, die zugleich als Abschirmwand ausgebildet sein kann. Auf der Vorderseite dieser Verdrahtungsplatte sind außer den externen Kabeln auch Leiterplatten-Baugruppen angesteckt, die die Überspannungsableiter für sämtliche Sprechadern enthalten, während auf der Ruckseite Leiterplatten-Baugruppen angeschlossen sind, auf denen die Filter gegen interne Störspannungen zusammengefaßt sind. Die beiderseits auf der Verdrahtungsplatte sitzenden Anschlußleisten haben jeweils die gleichen, die Platte durchdringenden Kontaktstifte. Die Baugruppen mit den Überspannungsableitern tragen an der Vorderkante jeweils einen Massekontakt, der beim Einstecken der Baugruppe in den Baugruppenträger eine an dessen Querträger angebrachte, geerdete Sammelschiene kontaktiert, wie dies in der DE-OS 34 12 130 beschrieben ist.

Der Erfindung liegt die Aufgabe zugrunde, eine andere Abschirmung für einen Eingangsverteiler in Form eines Baugruppenträgers zu schaffen, die den Durchtritt von Störstrahlung in die oder aus der Anlage verhindert und auftretende Überspannungen ableitet. Gelöst wird diese Aufgabe durch die im Anspruch 1 angegebenen Merkmale. Weiterbildungen sind den Unteransprüchen zu entnehmen. Diese Konstruktion hat den Vorteil, daß die Kontaktfedern einerseits der Baugruppe mechanisch einen festen Sitz im Baugruppenträger verleihen und durch Überwinden eines Druckpunktes beim Steckvorgang den eingeschobenen Zustand fühlbar machen, andererseits elektrisch die Ableitung sowohl von Überspannungen als auch von Störstrahlungen in sich vereinen.

Die Erfindung wird an einem Ausführungsbeispiel beschrieben, das in den zugehörigen Zeichnungen dargestellt ist. Darin zeigen:

Fig. 1 einen Ausschnitt aus der Rückwand eines den Eingangsverteiler einer Fernsprechnebenstellenanlage aufnehmenden Baugruppenträgers mit zwei eingesetzten Leiterplatten-Baugruppen, in perspektivischer Ansicht, und

Fig. 2 einen vergrößerten Ausschnitt aus der Anordnung nach Fig. 1, der die Verbindung zwischen Baugruppen und Rückwand mittels Kontaktfedern wiedergibt.

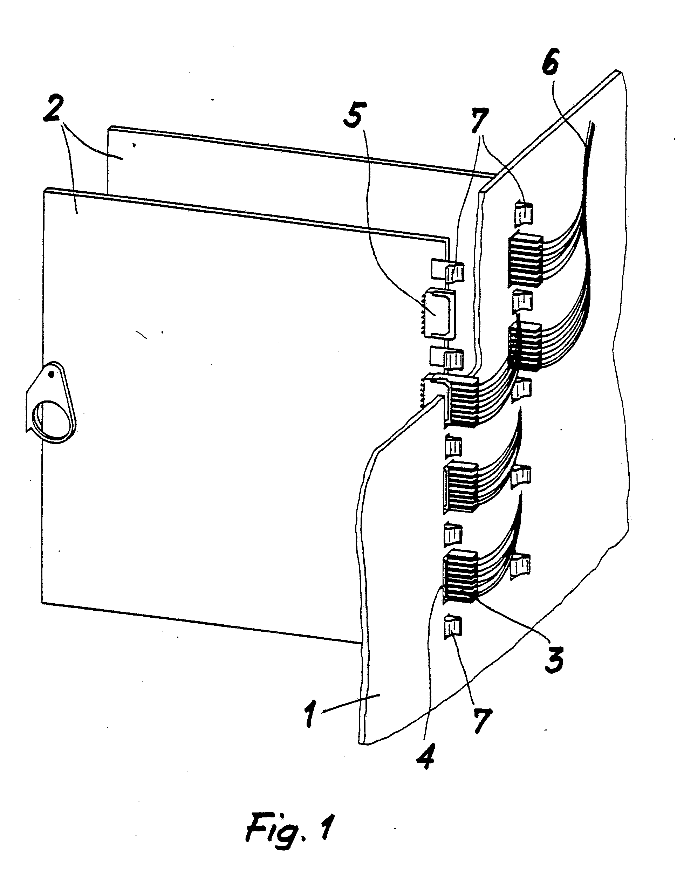

In den Figuren ist die Rückwand eines in der Fernsprechvermittlungstechnik üblichen Baugruppenträgers mit 1 und zwei angesteckte Leiterplatten-Baugruppen sind mit 2 bezeichnet. Die übrigen Teile des Baugruppenträgers, wie Rahmen, Seitenwände, Querträger, Führungsschienen für die Baugruppen, sind nicht dargestellt, da sie für die Erfindung unerheblich sind. Von den zahlreichen, in den Baugruppenträger einsetzbaren Baugruppen 2 sind in Fig. 1 nur zwei dargestellt und von der Rückwand 1 nur der Teil, an den die beiden Baugruppen anstoßen.

Die Rückwand 1 besteht aus einem Blech und bildet eine Abschirmwand, die den Ein- oder Austritt von Störstrahlungen verhindern, aber auch Überspannungen ableiten soll, die in den Baugruppen 2 auftreten können. Dies gilt insbesondere für Baugruppenträger, die Baugruppen mit Schaltungen für den Überspannungsschutz sowie für die Leitungsfilterung enthalten, wie sie für Vermittlungsanlagen notwendig sind.

Die elektrischen Anschlüsse der Baugruppen 2 erfolgen, wie üblich, über Anschlußleisten, deren einer Teil 5 (z.B. Messerleiste) jeweils stirnseitig an den Baugruppen 2 und deren komplementärer Teil 3 (z.B. Federleiste) jeweils an den internen Kabeln 6 der Gestellverkabelung befestigt ist. Die Anschlußleisten 5 kommen beim Einschieben einer Baugruppe 2 in den Baugruppenträger jeweils in entsprechenden Durchbrüchen 4 der Rückwand 1 zu stehen. Die Anschlußleisten 3 der Kabel 6 werden von der anderen Seite der Rückwand an die Anschlußleisten 5 der Baugruppe 2 angesteckt, die mit deren Leiterbahnen verbunden sind (nicht dargestellt).

Für die Ableitung von Stör- und Überspannungen sind besondere Kontaktfedern 7 vorgesehen, die an der Baugruppe 2 befestigt sind und beim Steckvorgang entsprechende Durchbrüche 8 in der Rückwand 1 durchsetzen. Die Kontaktfedern 7 sind, wie Fig. 1 erkennen läßt, neben bzw. zwischen den Anschlußleisten 5 angeordnet, so daß jede Anschlußleiste an beiden Schmalseiten von einer Kontaktfeder flankiert wird.

Die Kontaktfedern 7 bestehen jeweils aus einem im wesentlichen rechteckigen, länglichen Stück Federbandmetall, das einen geraden, langen Schenkel 9 bildet und an einem Ende zurückgebogen ist, wobei sich der zurückgebogene Schenkel in einem bogenförmigen Teil 11 von dem langen Schenkel 9 entfernt und nach einem Knick in einen geraden Abschnitt 12 übergeht, der etwa parallel zum geraden Schenkel 9 verläuft, was besonders Fig. 2 verdeutlicht. Der Abstand der beiden parallelen Schenkel ist etwas größer als die Breite des Durchbruchs 8 in der Rückwand 1, so daß sie beim Einfahren federnd zusammengedrückt werden. Das Ende des parallelen, geraden Abschnittes 12 ist rechtwinklig nach außen abgebogen und bildet einen Anschlag 13, der das Durchrutschen des kurzen Schenkels der Kontaktfeder 7 durch den Durchbruch 8 verhindert.

Die Befestigung der Kontaktfedern 7 an der Baugruppe 2 geschieht mittels am anderen Ende des langen Schenkels 9 angeformter, rechtwinklig abgebogener Ansätze 14, die in üblicher Weise durch entsprechende Löcher in der Leiterplatte der Baugruppe 2 gesteckt und mit deren Masseleiterbahnen verlötet sind.

**Ansprüche**

1. Eingangsverteiler für Fernsprechnebenstellenanlagen, der einen Baugruppenträger mit einer Rückwand und mit eingeschobenen Baugruppen aufweist, wobei letztere über Anschlußleisten mit der Verkabelung verbunden sind, **dadurch gekennzeichnet,** daß die Rückwand (1) von einer Metallplatte gebildet wird und daß zwischen den Anschlußleisten (5) jeder Baugruppe (2) Kontaktfedern (7) angeordnet sind, die mit den Masseleiterbahnen der Baugruppe verbunden sind und in entsprechende Durchbrüche (8) der Rückwand federnd eingreifen.

2. Eingangsverteiler nach Anspruch 1, dadurch gekennzeichnet, daß jede Anschlußleiste (5) einer Baugruppe (2) an ihren Schmalseiten jeweils von einer Kontaktfeder (7) flankiert wird.

3. Eingangsverteiler nach Anspruch 2, dadurch gekennzeichnet, daß die Kontaktfeder (7) rechteckigen Grundriß hat, einen geraden, langen Schenkel (9) bildet, der an einem Ende an der Baugruppe (2) befestigt und am freien Ende zurückgebogen ist und mittels eines bogenförmigen Teils (11) in einen kurzen, geraden, parallel zum langen Schenkel (9) liegenden Abschnitt (12) übergeht, dessen Ende rechtwinklig nach außen abgebogen ist und einen Anschlag (13) bildet, der sich an der Kante des Durchbruchs (8) anlegt.

4. Eingangsverteiler nach Anspruch 1, dadurch gekennzeichnet, daß die Metallplatte (1) mit Durchbrüchen (4) versehen ist, durch die hindurch die Verbindungen zwischen den Anschlußleisten (5) der Baugruppen (2) und den Kabelsteckern (3) der internen Kabel (6) erfolgen.

Fig. 1